# EUROPÄISCHE PATENTSCHRIFT

(11) **EP 3 556 187 B1**
(45) Veröffentlichungstag und Bekanntmachung des Hinweises auf die Patenterteilung: **24.07.2024**
(21) Anmeldenummer: 17792013.9
(22) Anmeldetag: 20.10.2017
(51) Int. Cl.: H05K 1/18, H05K 3/32, H05K 5/00, H05K 3/28, H05K 3/30

(54) **GETRIEBESTEUERUNGSEINRICHTUNG UND VERFAHREN ZUM BEFESTIGEN EINES SIGNALEINGABEELEMENTS AN EINEM LEITERPLATTENELEMENT EINER GETRIEBESTEUERUNGSEINRICHTUNG**
TRANSMISSION CONTROL APPARATUS AND METHOD FOR FASTENING A SIGNAL INPUT ELEMENT TO A CIRCUIT BOARD ELEMENT OF A TRANSMISSION CONTROL APPARATUS
DISPOSITIF DE COMMANDE DE TRANSMISSION ET PROCÉDÉ DE FIXATION D'UN ÉLÉMENT D'ENTRÉE DE SIGNAL À UN ÉLÉMENT DE CARTE DE CIRCUIT IMPRIMÉ D'UN DISPOSITIF DE COMMANDE DE TRANSMISSION

(30) Priorität: 13.12.2016 DE 102016224799
(43) Veröffentlichungstag der Anmeldung: 23.10.2019
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2017/076849
(87) Internationale Veröffentlichungsnummer: WO 2018/108363

(56) Entgegenhaltungen:
- WO-A1-2015/014697
- DE-A1- 102010 029 868
- DE-A1- 102011 088 037
- DE-A1- 102014 224 033
- DE-A1- 19 717 348

## Beschreibung

### Gebiet der Erfindung

Die Erfindung betrifft eine Getriebesteuerungseinrichtung und ein Verfahren zum Befestigen eines Signaleingabeelements an einem Leiterplattenelement einer Getriebesteuerungseinrichtung.

### Stand der Technik

Bei bisher bekannten Getriebesteuerungseinrichtungen, die ein Leiterplattenelement umfassen, werden Signaleingabeelemente zum Eingeben eines Signals in das Leiterplattenelement (z.B. eine Sensorvorrichtung und/oder ein Verbindungsstecker) auf den Leiterplattenelementen z.B. durch Schrauben oder Nietverbindungen befestigt oder in diese integriert. Die aus dem Signaleingabeelement herausragenden Anschlussleitungen werden in das Leiterplattenelement oder in Flexfolien (hierbei werden Durchsteck-Lötkontakte verwendet) oder in weiterleitende Stanzgitter eingesteckt und an diese geschweißt oder gelötet. Diese Stanzgitter, Flexfolien oder Leiterplattenelemente verbinden das Signaleingabeelement mit einem zentralen Getriebesteuergerät iTCU oder einem Getriebestecker.

Nachteilig hieran ist, dass die Position des Signaleingabeelements (Sensor bzw. Verbindungsstecker) in Bezug auf das Leiterplattenelement fix ist und eine Veränderung der Position üblicherweise eine grundlegende Designänderung des Leiterplattenelements notwendig macht. Darüber hinaus ist das Herstellen der elektrischen Verbindung zwischen Signaleingabeelement und Leiterplattenelement oder ähnlichem in der Regel technisch aufwändig.

Aus der DE 10 2010 029868 A1 ist eine Getriebesteuerungseinrichtung bekannt, welche ein Leiterplattenelement aufweist, wobei auf einer ersten Oberfläche des Leiterplattenelements ein Sockel mit einem Hohlraum zum Aufnehmen zumindest eines Teils eines Signaleingabeelements befestigt ist. Das Signaleingabeelement ist als Drucksensorvorrichtung mit einem Sensor und Anschlussleitungen ausgebildet und zumindest teilweise in dem Hohlraum befestigt ist und über den Sockel elektrisch mit dem Leiterplattenelement verbunden, wobei das Leiterplattenelement eine Aussparung zum Einführen des Signaleingabeelements in den Hohlraum durch das Leiterplattenelement aufweist.

Aus der WO 2015/014697 A1 ist ein Elektronikmodul bekannt, das ein erstes Leiterplattenelement mit wenigstens einem daran angeordneten elektronischen Bauelement und ein zweites Leiterplattenelement mit wenigstens einem daran angeordneten elektrischen Bauelement sowie einen Abstandhalter aufweist. Das erste Leiterplattenelement, das zweite Leiterplattenelement und der Abstandhalter umhüllen einen zentralen Hohlraum, in dem das elektronische Bauelement des ersten Leiterplattenelements aufgenommen ist. Entlang eines äußeren Umfangs des ersten Leiterplattenelements ist ein Dichtring ausgebildet, der in formschlüssiger Verbindung sowohl einer an dem ersten Leiterplattenelement ausgebildeten Mikrostrukturierung als auch in formschlüssiger Verbindung mit einer an dem zweiten Leiterplattenelement ausgebildeten Mikrostrukturierung steht.

### Offenbarung der Erfindung

### Vorteile der Erfindung

Ausführungsformen der vorliegenden Erfindung können in vorteilhafter Weise ermöglichen, technisch einfach ein Signaleingabeelement auf dem Leiterplattenelement der Getriebesteuerungseinrichtung anzuordnen.

Gemäß einem ersten Aspekt der Erfindung wird eine Getriebesteuerungseinrichtung, insbesondere für ein Kraftfahrzeug, umfassend ein Leiterplattenelement vorgeschlagen, wobei auf einer ersten Oberfläche des Leiterplattenelements ein Sockel mit einem Hohlraum zum Aufnehmen zumindest einen Teils eines Signaleingabeelements befestigt ist, wobei das Signaleingabeelement zumindest teilweise in dem Hohlraum befestigt ist und über den Sockel elektrisch mit dem Leiterplattenelement verbunden ist, wobei das Leiterplattenelement eine Aussparung zum Einführen des Signaleingabeelements in den Hohlraum durch das Leiterplattenelement aufweist, wobei das Signaleingabeelement als Sensorvorrichtung mit einem Sensordom, einem Sensor und Anschlussleitungen ausgebildet ist. Erfindungsgemäß ist eine erste Fixierungsschicht zum Abdichten des Bereichs zwischen dem Sockel und dem Leiterplattenelement auf der ersten Oberfläche des Leiterplattenelements und auf einem Teil des Sockels angeordnet, wobei das Signaleingabeelement über Anschlusselemente des Sockels elektrisch mit dem Leiterplattenelement verbunden ist, wobei die Anschlusselemente aus dem Sockel in den Hohlraum in Richtung des Signaleingabeelements hervorstehen und die Anschlusselemente gegen eine oder mehrere Anschlussleitungen des Signaleingabeelements drücken und auf diese Weise die Sensorvorrichtung zwischen sich einklemmen.

Ein Vorteil hiervon ist, dass das Signaleingabeelement in der Regel technisch einfach an dem Leiterplattenelement befestigt und mit diesem elektrisch verbunden ist. Zudem kann das Signaleingabeelement im Allgemeinen ein kostengünstiges Thermoplastmaterial umfassen bzw. aus diesem bestehen, da das Signaleingabeelement erst nach dem Reflowlöten in den Hohlraum des Sockels eingebracht wurde. Somit muss das Signaleingabeelement in der Regel Temperaturen von ca. 250 °C bis ca. 270 °C, die in einem Reflow-Lötofen typischerweise vorhanden sind, nicht standhalten. Daher sind in der Regel andere Materialien für das Signaleingabeelement möglich. Das Signaleingabeelement ist eine Sensorvorrichtung mit einem Sensor. Zudem kann üblicherweise die Höhe, d.h. der Abstand der oberen Oberfläche des Signaleingabeelements bzw. der Sensorvorrichtung zu der ersten (oberen) Oberfläche des Leiterplattenelements größer sein als die sonst üblicherweise maximal zulässige Bestückungshöhe (z.B. 25 mm bis 30 mm), die durch die freie Höhe des Reflow-Lötofen vorgegeben ist. Somit sind Getriebesteuerungseinrichtungen mit Signaleingabeelementen bzw. Sensorvorrichtungen in der Regel möglich, die einen maximalen Abstand (Abstand der oberen am weitesten entfernten Oberfläche) von der ersten Oberfläche des Leiterplattenelements von ca. 25 mm bis ca. 100 mm und mehr zu der ersten Oberfläche aufweisen. Das Signaleingabeelement erzeugt elektrische Signale und überträgt diese an das Leiterplattenelement (Sensorvorrichtung).

Gemäß einem weiteren Aspekt der Erfindung wird ein Verfahren zum Befestigen eines Signaleingabeelements an einem Leiterplattenelement einer Getriebesteuerungseinrichtung, insbesondere für ein Kraftfahrzeug, vorgeschlagen, wobei das Verfahren folgende Schritte umfasst: Bereitstellen des Leiterplattenelements, wobei das Leiterplattenelement eine Aussparung zum Einführen des Signaleingabeelements aufweist; Anordnen eines Sockels mit Anschlusselementen auf einer ersten Oberfläche des Leiterplattenelements, wobei der Sockel die Aussparung auf der ersten Oberfläche des Leiterplattenelements im Wesentlichen umschließt und der Sockel einen Hohlraum zum Aufnehmen des Signaleingabeelements aufweist, wobei das Signaleingabeelement als Sensorvorrichtung mit einem Sensordom, einem Sensor und Anschlussleitungen ausgebildet ist; Elektrisches Verbinden der Anschlusselemente mit dem Leiterplattenelement. Erfindungsgemäß umfasst das Verfahren die folgenden Schritte: Aufbringen einer ersten Fixierungsschicht auf die erste Oberfläche des Leiterplattenelements und auf einen Teil des Sockels zum Abdichten des Bereichs zwischen dem Sockel und dem Leiterplattenelement; Aushärten der ersten Fixierungsschicht;
und Einführen des Signaleingabeelements durch die Aussparung des Leiterplattenelements in den Hohlraum des Sockels und Befestigen des Signaleingabeelements an dem Leiterplattenelement, wobei das Signaleingabeelement über Anschlusselemente des Sockels elektrisch mit dem Leiterplattenelement verbunden wird, wobei die Anschlusselemente aus dem Sockel in den Hohlraum in Richtung des Signaleingabeelements hervorstehen und die Anschlusselemente gegen eine oder mehrere Anschlussleitungen des Signaleingabeelements drücken und auf diese Weise die Sensorvorrichtung zwischen sich einklemmen.

Ein Vorteil hiervon ist, dass das Signaleingabeelement in der Regel technisch einfach an dem Leiterplattenelement befestigt und mit diesem elektrisch verbunden wird. Zudem kann das Signaleingabeelement im Allgemeinen ein kostengünstiges Thermoplastmaterial umfassen bzw. aus diesem bestehen, da das Signaleingabeelement erst nach dem Reflowlöten in den Hohlraum des Sockels eingebracht wird. Somit muss das Signaleingabeelement in der Regel Temperaturen von ca. 250 °C bis ca. 270 °C, die in einem Reflow-Lötofen typischerweise vorhanden sind, nicht standhalten. Daher sind in der Regel andere Materialien für das Signaleingabeelement möglich. Üblicherweise kann das Signaleingabeelement eine Sensorvorrichtung mit einem Sensor oder ein Verbindungsstecker (weiblich oder männlich) sein. Zudem kann üblicherweise die Höhe, d.h. der Abstand der oberen Oberfläche der Sensorvorrichtung bzw. des Verbindungssteckers zu der ersten (oberen) Oberfläche des Leiterplattenelements größer sein als die sonst üblicherweise maximal zulässige Bestückungshöhe (z.B. 25 mm bis 30 mm), die durch die freie Höhe des Reflow-Lötofen vorgegeben ist. Somit sind auf diese Weise Getriebesteuerungseinrichtungen mit Sensorvorrichtungen bzw. Verbindungssteckern in der Regel herstellbar, die einen maximalen Abstand (Abstand der oberen am weitesten entfernten Oberfläche) von der ersten Oberfläche des Leiterplattenelements von ca. 25 mm bis ca. 100 mm und mehr zu der ersten Oberfläche aufweisen. Das Signaleingabeelement kann insbesondere elektrische Signale erzeugen und diese an das Leiterplattenelement übertragen (Sensorvorrichtung)

Ideen zu Ausführungsformen der vorliegenden Erfindung können unter anderem als auf den nachfolgend beschriebenen Gedanken und Erkenntnissen beruhend angesehen werden.

Gemäß einer Ausführungsform weist das Signaleingabeelement eine zumindest teilweise außerhalb des Hohlraums angeordnete Vertiefung zum Aufnehmen einer zweiten Fixierungsschicht auf. Ein Vorteil hiervon ist, dass typischerweise eine besonders sichere Verbindung zwischen dem Signaleingabeelement und dem Sockel vorhanden ist.

Gemäß einer Ausführungsform sind die Anschlusselemente federnd ausgebildet, wobei das Signaleingabeelement mittels der Anschlusselemente an dem Leiterplattenelement befestigt ist. Ein Vorteil hiervon ist, dass das Signaleingabeelement in der Regel technisch einfach gleichzeitig mechanisch und elektrisch mit dem Sockel bzw. dem Leiterplattenelement verbunden ist. Zudem kann das Signaleingabeelement typischerweise an unterschiedlichen Positionen bzw. unterschiedlichen Einschiebtiefen innerhalb des Hohlraums befestigt sein.

Gemäß einer Ausführungsform steht ein Teil des Signaleingabeelements auf einer von dem Leiterplattenelement abgewandten Seite des Sockels aus dem Sockel hervor. Hierdurch ist in der Regel eine gute und technisch einfache Signalerfassung (durch die Sensorvorrichtung) vorhanden.

Gemäß einer Ausführungsform ist der Sockel in der Richtung von dem Leiterplattenelement weg sich verjüngend ausgebildet. Ein Vorteil hiervon ist, dass die Positionierung des Signaleingabeelements in dem Hohlraum in der Regel technisch einfach und präzise durchführbar ist.

Gemäß einer Ausführungsform ist der in den Hohlraum hervorstehende Teil des jeweiligen Anschlusselements federnd ausgebildet, und wobei das Signaleingabeelement an dem Leiterplattenelement mittels der in den Hohlraum hervorstehenden Teile der Anschlusselemente befestigt wird. Ein Vorteil hiervon ist, dass das Signaleingabeelement in der Regel technisch einfach gleichzeitig mechanisch und elektrisch mit dem Sockel bzw. dem Leiterplattenelement verbunden werden kann.

Gemäß einer Ausführungsform kann das Signaleingabeelement an unterschiedlichen Positionen in einer Richtung senkrecht zu der ersten Oberfläche des Leiterplattenelements in dem Hohlraum fixiert werden. Ein Vorteil hiervon ist, dass das Signaleingabeelement typischerweise an unterschiedlichen Positionen bzw. unterschiedlichen Einschiebtiefen innerhalb des Hohlraums befestigt werden kann. Hierdurch kann in der Regel ein Abstand eines Sensors der Sensorvorrichtung zu der Vorrichtung, deren Werte erfasst werden sollen, technisch einfach eingestellt werden.

Gemäß einer Ausführungsform umfasst das Verfahren ferner folgenden Schritt: Aufbringen einer zweiten Fixierungsschicht auf einen Teil des Sockels und einen Teil des Signaleingabeelements zum Befestigen des Signaleingabeelements an dem Sockel. Ein Vorteil hiervon ist, dass in der Regel eine sichere und technisch einfache Befestigung des Signaleingabeelements an dem Sockel erreicht wird.

Es wird darauf hingewiesen, dass einige der möglichen Merkmale und Vorteile der Erfindung hierin mit Bezug auf unterschiedliche Ausführungsformen der Getriebesteuerungseinrichtung beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine Querschnittsansicht einer ersten Ausführungsform der erfindungsgemäßen Getriebesteuerungseinrichtung vor dem Einsetzen der Sensorvorrichtung in den Hohlraum;
- Fig. 2 zeigt: eine Querschnittsansicht der Sensorvorrichtung aus Fig. 1 entlang der Linie II-II;
- Fig. 3 zeigt: eine Querschnittsansicht einer zweiten Ausführungsform der Sensorvorrichtung;
- Fig. 4 zeigt: eine weitere Querschnittsansicht der Sensorvorrichtung aus Fig. 3 entlang der Linie IV-IV;
- Fig. 5 zeigt: eine Querschnittsansicht der Getriebesteuerungseinrichtung aus Fig. 1 nach dem Einsetzen der Sensorvorrichtung in den Hohlraum;
- Fig. 6 zeigt: eine Querschnittsansicht einer zweiten Ausführungsform und einer dritten Ausführungsform der erfindungsgemäßen Getriebesteuerungseinrichtung nach dem Einsetzen der Sensorvorrichtung in den Hohlraum; und
- Fig. 7 zeigt: eine Querschnittsansicht der Getriebesteuerungseinrichtung aus Fig. 5, wobei die Getriebesteuerungseinrichtung auf einer Grundplatte angeordnet ist.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

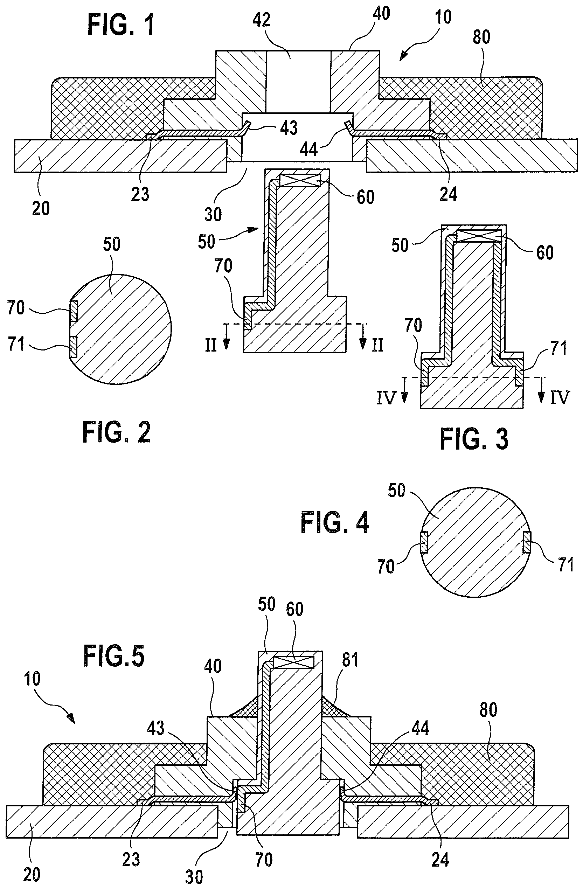

Fig. 1 zeigt eine Querschnittsansicht einer ersten Ausführungsform der erfindungsgemäßen Getriebesteuerungseinrichtung 10 vor dem Einsetzen bzw. Einführen der Sensorvorrichtung in den Hohlraum 42. Fig. 2 zeigt eine Querschnittsansicht der Sensorvorrichtung aus Fig. 1 entlang der Linie II-II. Fig. 3 zeigt eine Querschnittsansicht einer zweiten Ausführungsform der Sensorvorrichtung. Fig. 4 zeigt eine weitere Querschnittsansicht der Sensorvorrichtung aus Fig. 3 entlang der Linie IV-IV. Fig. 5 zeigt eine Querschnittsansicht der Getriebesteuerungseinrichtung 10 aus Fig. 1 nach dem Einsetzen der Sensorvorrichtung in den Hohlraum 42.

Die Getriebesteuerungseinrichtung 10 umfasst ein Leiterplattenelement 20, z.B. ein Printed-Circuit-Board (PCB), einen Sockel 40 und ein Signaleingabeelement 50. Das Signaleingabeelement 50 gibt elektrische Signale in das Leiterplattenelement 20 ein. Das Signaleingabeelement 50 erzeugt selbst elektrische Signale und überträgt diese an das Leiterplattenelement 20 (Sensorvorrichtung).

Die Sensorvorrichtung umfasst einen Sensor 60. Der Sensor 60 kann z.B. ein Sensor 60 zum Erfassen der Drehzahl sein.

Die Getriebesteuerungseinrichtung 10 ist zum Steuern eines Getriebes, insbesondere eines Kraftfahrzeugs, ausgebildet.

Das Leiterplattenelement 20 weist eine Aussparung 30 auf, die sich über die gesamte Höhe des Leiterplattenelements 20 erstreckt. Die Höhe des Leiterplattenelements 20 verläuft in Fig. 1 von unten nach oben.

Der Sockel 40 ist auf einer ersten Oberfläche (in Fig. 1 die obere Oberfläche) des Leiterplattenelements 20 angeordnet. Teilweise ist der Sockel 40 auch in der Aussparung 30 angeordnet. Der Sockel 40 weist einen Hohlraum 42 auf, der komplementär zu der Sensorvorrichtung ausgebildet ist. Der Hohlraum 42 verjüngt sich stufenweise von unten nach oben. Dementsprechend verjüngt sich die Sensorvorrichtung von unten nach oben in Fig. 1. Zumindest der Teil der Sensorvorrichtung, der im Hohlraum 42 aufgenommen wird, ist sich verjüngend ausgebildet. Der aus dem Hohlraum 42 (in Fig. 5 nach oben) hervorstehende Teil der Sensorvorrichtung kann wieder breiter sein als ein Teil der Sensorvorrichtung, die im Hohlraum 42 angeordnet ist.

Der Sockel 40 weist zwei Anschlusselemente 43, 44 auf, die auf einander gegenüberliegenden Seiten des Sockels 40 angeordnet sind. Der Sockel 40 ist über die Anschlusselemente 43, 44 mit dem Leiterplattenelement 20 bzw. den (nicht gezeigten) elektronischen Bauelement auf dem Leiterplattenelement 20 elektrisch verbunden. Hierzu stehen die Anschlusselemente 43, 44 auf einer dem Hohlraum 42 abgewandten Seite aus dem Sockel 40 heraus. An dieser Stelle sind die Anschlusselemente 43, 44 mit der Leiterplatte elektrisch verbunden. Dies kann beispielsweise durch SMD-Löten durchgeführt werden. Die Anschlusselemente 43, 44 sind über SMD-Lötstellen 23, 24 mit dem Leiterplattenelement 20 elektrisch verbunden.

Jeweils ein Teil der Anschlusselemente 43, 44 steht in den Hohlraum 42 hinein aus dem Sockel 40 hervor. Die Sensorvorrichtung wird durch die Aussparung 30 des Leiterplattenelements 20 durch das Leiterplattenelement 20 geschoben bzw. geführt und in den Hohlraum 42 des Sockels 40 geschoben.

Die Anschlusselemente 43, 44 bzw. der Teil der Anschlusselemente 43, 44, der jeweils aus dem Sockel 40 in den Hohlraum 42 hervorsteht, kann federnd ausgebildet sein. Die Sensorvorrichtung kann durch die Anschlusselemente 43, 44 in verschiedenen Positionen, bei denen die Sensorvorrichtung unterschiedlich tief in den Hohlraum 42 eingeschoben wurde, fixiert bzw. an dem Leiterplattenelement 20 befestigt werden.

Die Sensorvorrichtung kann zwei, drei, vier oder mehr Anschlussleitungen 70, 71 aufweisen, die elektrisch mit dem Sensor 60 verbunden sind und die zum elektrischen Verbinden mit den Anschlusselementen 43, 44 des Sockels 40 ausgebildet sind.

Die Anschlussleitungen 70, 71 können parallel zueinander verlaufen (siehe Fig. 2). Alternativ können die Anschlussleitungen 70, 71 an gegenüberliegenden Seiten der Sensorvorrichtung angeordnet sein (siehe Fig. 3 bzw. Fig. 4). Hierdurch wird verhindert, dass sich leitende Ablagerungen, die einen Kurzschluss zwischen den Anschlussleitungen 70, 71 auslösen, zwischen den Anschlussleitungen 70, 71 bilden können, da der Abstand der beiden Anschlussleitungen 70, 71 maximal groß ist. Bei parallel zueinander verlaufenden Anschlussleitungen 70, 71 kann die Bildung von leitenden Ablagerungen, die einen Kurzschluss zwischen den Anschlussleitungen 70, 71 auslösen, verhindert werden, indem ein Steg bzw. ein Vorsprung zwischen den Anschlussleitungen 70, 71 ausgebildet ist bzw. vorhanden ist.

Auch wenn die elektrisch aktiven Anschlussleitungen 70, 71 beide bzw. alle auf einer Seite der Sensorvorrichtung angeordnet sind (siehe Fig. 2) kann der Sockel 40 Anschlusselemente 43, 44 aufweisen, die an einander gegenüberliegenden Seiten des Hohlraums 42 in den Hohlraum 42 vorstehen. Dies bedeutet, dass auch nicht-elektrisch-aktive Anschlusselemente 43, 44 zur Fixierung und seitlichen Anpressung der Sensorvorrichtung verwendet werden können. Hierdurch kann eine besonders gleichmäßige und/oder symmetrische Befestigung der Sensorvorrichtung in dem Sockel 40 erreicht werden.

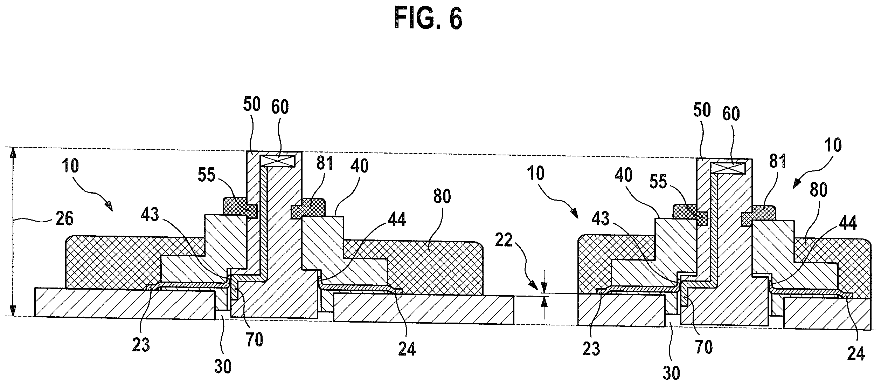

Fig. 6 zeigt eine Querschnittsansicht einer zweiten Ausführungsform und einer dritten Ausführungsform der erfindungsgemäßen Getriebesteuerungseinrichtung 10 nach dem Einsetzen der Sensorvorrichtung in den Hohlraum 42. Im linken Teil bzw. Bereich der Fig. 6 ist die zweite Ausführungsform der erfindungsgemäßen Getriebesteuerungseinrichtung 10 nach dem Einsetzen der Sensorvorrichtung in den Hohlraum 42 zu sehen. Im rechten Teil bzw. Bereich der Fig. 6 ist die dritte Ausführungsform der der erfindungsgemäßen Getriebesteuerungseinrichtung 10 nach dem Einsetzen der Sensorvorrichtung in den Hohlraum 42 zu sehen.

Die Höhe bzw. Dicke des Leiterplattenelements 20 (die Höhe bzw. Dicke verläuft in Fig. 6 von unten nach oben) kann herstellungsbedingt variieren. Die Dicke bzw. Höhe des Leiterplattenelements 20 kann z.B. 1,6 mm ± 0,15 mm betragen. Der Höhenunterschied 22 ist durch die Verbindungslinien zwischen dem linken Teil der Fig. 6 und dem rechten Teil der Fig. 6 dargestellt. Durch die variable Einschiebtiefe der Sensorvorrichtung in den Hohlraum 42 kann ein Abstand des Sensors 60 mit einer Vorrichtung, dessen Eigenschaften gemessen werden soll, fein eingestellt werden. Durch die variable Einschiebtiefe der Sensorvorrichtung in den Hohlraum 42 können unterschiedliche Höhen bzw. Dicken des Leiterplattenelements 20 ausgeglichen werden. D.h. der Abstand zwischen dem Sensor 60 und der zweiten der ersten abgewandten Oberfläche/der Unterseite des Leiterplattenelements 20 bzw. die bzw. die Gesamthöhe 26 der Getriebesteuerungseinrichtung 10 kann stets gleich eingestellt werden (siehe linker Teil der Fig. 6 bzw. zweite Ausführungsform und rechter Teil der Fig. 6 bzw. dritte Ausführungsform).

Bei der im linken Teil der Fig. 6 gezeigten zweiten Ausführungsform der erfindungsgemäßen Getriebesteuerungseinrichtung 10 ist die Sensorvorrichtung bis zum Anschlag bzw. soweit es geht in den Hohlraum 42 (nach oben) geschoben. Zwischen der Sensorvorrichtung und dem Sockel 40 kann ein gewisses Spiel (in einer Richtung parallel zu der ersten Oberfläche des Leiterplattenelements 20) vorhanden sein.

Bei der im rechten Teil der Fig. 6 gezeigten dritten Ausführungsform der erfindungsgemäßen Getriebesteuerungseinrichtung 10 ist die Sensorvorrichtung nicht bis zum Anschlag bzw. nicht so weit es geht in den Hohlraum 42 (nach oben) geschoben, sondern ein Abstand in der Höhenrichtung ist zwischen der Sensorvorrichtung und dem Sockel 40 ist vorhanden.

Die Sensorvorrichtung kann eine Vertiefung 55 bzw. Einschnürung aufweisen, die bei eingeführter Sensorvorrichtung in den Hohlraum 42 zumindest teilweise freiliegt, d.h. sich außerhalb des Hohlraums 42 des Sockels 40 befindet. Die Vertiefung 55 kann punktuell bzw. partiell oder umlaufend um die Sensorvorrichtung ausgebildet sein. Die Vertiefung 55 dient zum Aufnahme des Materials einer zweiten Fixierungsschicht 81. Die zweite Fixierungsschicht 81 kann z.B. ein Klebstoff und/oder ein Lack sein. Die zweite Fixierungsschicht 81 wird auf einen Teil (den oberen Teil) des Sockels 40 und einen Teil der Sensorvorrichtung, die nach oben aus dem Hohlraum 42 des Sockels 40 hervorstehe, aufgebracht. Hierdurch wird eine besonders sichere Befestigung der Sensorvorrichtung an dem Sockel 40 bzw. an dem Leiterplattenelement 20 erreicht. Zudem wird eine Arretierung der Sensorvorrichtung in der Höhe hierdurch erreicht.

Die Vertiefung 55 ist insbesondere dann vorteilhaft, wenn die zweite Fixierungsschicht 81 besser auf dem Sockel 40 als auf der Sensorvorrichtung haftet. Auch ist die Vertiefung 55 insbesondere vorteilhaft, wenn der Sockel 40 einen Wärmeausdehnungskoeffizienten aufweist, der sich von dem Wärmeausdehnungskoeffizienten der Sensorvorrichtung unterscheidet. Dies ist z.B. möglich, wenn der Sockel 40 aus Duroplastmaterial mit einem Wärmeausdehnungskoeffizienten von ca. 20 ppm/K, die zweite Fixierungsschicht 81 einen Wärmeausdehnungskoeffizienten von ca. 15 ppm/K bis ca. 25 ppm/K und die Sensorvorrichtung einen Wärmeausdehnungskoeffizienten von ca. 65 ppm/K aufweist. Das Leiterplattenelement 20 weist üblicherweise einen Wärmeausdehnungskoeffizienten von ca. 18 ppm/K auf.

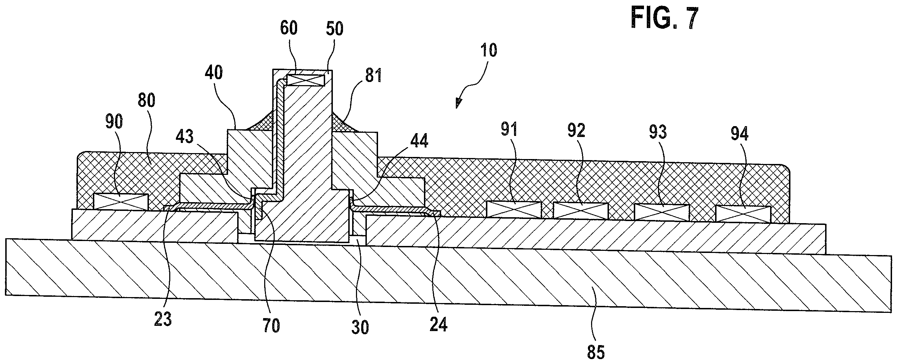

Fig. 7 zeigt eine Querschnittsansicht der Getriebesteuerungseinrichtung 10 aus Fig. 5, wobei die Getriebesteuerungseinrichtung 10 auf einer Grundplatte 85 angeordnet ist.

Die Getriebesteuerungseinrichtung 10 kann auf einer Grundplatte 85 angeordnet werden. Die Grundplatte 85 kann z.B. Teil des Getriebegehäuses sein, das das Getriebe aufnimmt. Hierdurch ist die Sensorvorrichtung von unten bzw. die Aussparung 30 in dem Leiterplattenelement 20 öldicht abgedichtet.

Die Sensorvorrichtung ist so weit in den Hohlraum 42 eingeschoben, dass die Sensorvorrichtung nicht nach unten (in Fig. 7) aus dem Leiterplattenelement 20 hervorsteht.

Die Getriebesteuerungseinrichtung 10 wird wie folgt hergestellt. Zunächst wird ein Leiterplattenelement 20 (z.B. ein Printed Circuit Board; PCB) mit einer Aussparung 30 bzw. einem Loch bereitgestellt. Anschließend wird ein Sockel 40 um die Aussparung 30 herum (evtl. auch teilweise in der Aussparung 30) auf eine erste Oberfläche des Leiterplattenelements 20 (in Fig. 5 die obere Oberfläche des Leiterplattenelements 20) aufgebracht oder angeordnet oder ausgebildet. Dies kann z.B. während des Elektronikbestückungsprozesses des Leiterplattenelements 20 geschehen. Der Sockel 40 kann über seinen Bund (der in der Aussparung 30 angeordnet wird) in der Aussparung 30 und/oder über Pins positioniert und vorfixiert werden.

Der Sockel 40 weist einen Hohlraum 42 zum Aufnehmen der Sensorvorrichtung und Anschlusselemente 43, 44 auf, die teilweise in den Hohlraum 42 hervorstehen. Die Anschlusselemente 43, 44 durchlaufen den Sockel 40 z.B. in horizontaler Richtung und stehen auf der dem Hohlraum 42 abgewandten Seite des Sockels 40 aus dem Sockel 40 hervor. Dieser nach außen hervorstehende Teil der Anschlusselemente 43, 44 wird elektrisch mit dem Leiterplattenelement 20 bzw. elektronischen Bauelementen 90-94 auf dem Leiterplattenelement 20 verbunden (z.B. mittels SMD-Lötstellen 23, 24). Nun wird eine erste Fixierungsschicht 80 bzw. eine Vergussmasse auf die erste Oberfläche des Leiterplattenelements 20 und den Sockel 40 aufgebracht und ausgehärtet (z.B. thermisch oder durch Strahlungsenergie). Die erste Fixierungsschicht 80 sorgt für eine sichere Befestigung des Sockels 40 an dem Leiterplattenelement 20. Gleichzeitig dichtet die erste Fixierungsschicht 80 die elektrischen Verbindungen zwischen den Anschlusselementen 43, 44 und dem Leiterplattenelement 20 öldicht ab.

Nun wird die Sensorvorrichtung, die einen Sensor 60 und Anschlusselemente 43, 44 aufweist, durch die Aussparung 30 in den Hohlraum 42 des Sockels 40 eingeführt. Der Sensor 60 kann z.B. ein ASIC, IC und/oder eine Spule sein. Der Sensor 60 kann auf einer Oberfläche der Sensorvorrichtung angeordnet sein oder kann in der Sensorvorrichtung angeordnet sein. Die Sensorvorrichtung weist eine (äußere) Form auf, die der Form des Hohlraums 42 entspricht. Beide sind sozusagen komplementär zueinander ausgebildet. Die Sensorvorrichtung wird je nach gewünschtem Abstand zwischen Sensor 60 und der unteren Oberfläche (die der ersten Oberfläche gegenüberliegt) des Leiterplattenelements 20 eingeschoben. Hierdurch kann z.B. ein Luftspalt zwischen dem Sensor 60 und dem zu messenden bzw. zu erfassenden Objekt (Sensor-Target) beispielsweise ein Triggerrad oder ein Positionsmagnet technisch einfach auf einen gewünschten Wert unabhängig von Herstellungstoleranzen der Höhe bzw. Dicke des Leiterplattenelements 20 eingestellt werden.

Die Anschlusselemente 43, 44 bzw. der Teil der Anschlusselemente 43, 44, der in den Hohlraum 42 hinein hervorsteht, können federnd ausgebildet sein. Die Anschlusselemente 43, 44 bilden eine typische Feder-Kontaktstelle. Die Anschlusselemente 43, 44 drücken (seitlich) gegen die Sensorvorrichtung (insbesondere gegen eine oder mehrere Anschlussleitungen 70, 71 der Sensorvorrichtungen) und klemmen auf diese Weise die Sensorvorrichtung zwischen sich ein. Hierdurch kann die Sensorvorrichtung an unterschiedlichen Position (in der Höhe, die in Fig. 1 von unten nach oben verläuft) arretiert werden. Die Positionen können in der Höhe kontinuierlich sein. Gleichzeitig wird durch die Anschlusselemente 43, 44 eine elektrische Verbindung mit den Anschlussleitungen 70, 71 der Sensorvorrichtung und somit mit dem Sensor 60 hergestellt. Anschließend kann optional eine zweite Fixierungsschicht 81 auf einen Teil des Sockels 40 und auf einen Teil der Sensorvorrichtung (der nach oben aus dem Sockel 40 hervorsteht) aufgebracht und ausgehärtet (z.B. thermisch oder durch Strahlungsenergie) werden. Die zweite Fixierungsschicht 81 arretiert die Sensorvorrichtung in der Höhe. Vorstellbar ist auch, dass die Anschlusselemente 43, 44 nicht federn ausgebildet sind, sondern eine Arretierung der Sensorvorrichtung in der Höhe ausschließlich durch die zweite Fixierungsschicht 81 stattfindet. Die zweite Fixierungsschicht 81 kann ein Klebstoff, eine Vergussmasse und/oder ein Lack sein. Die zweite Fixierungsschicht 81 kann z.B. Epoxidharz bzw. ein Epoxidharzkleber oder ein Polyacrylat bzw. Polyacrylatkleber sein.

Die erste Fixierungsschicht 80 kann ein Klebstoff, eine Vergussmasse und/oder ein Lack sein. Die erste Fixierungsschicht 80 kann z.B. Epoxidharz bzw. ein Epoxidharzkleber oder ein Polyacrylat bzw. Polyacrylatkleber sein.

Die erste Fixierungsschicht 80 und die zweite Fixierungsschicht 81 können aus dem gleichen Material bestehen.

Wenn der Sensor 60 der Sensorvorrichtung auf einer Außenoberfläche der Sensorvorrichtung angeordnet ist, kann die zweite Fixierungsschicht 81 auch den Sensor 60 bedecken. Vorstellbar ist auch, dass die zweite Fixierungsschicht 81 den ganzen bzw. kompletten Teil der Sensorvorrichtung, der aus dem Sockel 40 nach oben hinaussteht, bedeckt. Somit kann eine öldichte Abdeckung der Sensorvorrichtung erreicht werden.

Die erste Fixierungsschicht 80 ist zusammenhängend auf dem Leiterplattenelement 20 angeordnet. Die zweite Fixierungsschicht 81 ist zusammenhängend auf dem Sockel 40 und der Signalvorrichtung angeordnet.

Die Sensorvorrichtung weist einen Sensordom, den Sensor 60 und Anschlussleitungen 70, 71 auf. Der Sensor 60 ist in dem Sensordom oder auf einer Außenoberfläche des Sensordoms angeordnet. Der Sensordom bzw. die Sensorvorrichtung kann kostengünstiges Thermoplastmaterial umfassen bzw. aus diesem bestehen, da die Sensorvorrichtung erst nach dem Reflowlöten in den Hohlraum 42 des Sockels 40 eingebracht wird. Somit muss die Sensorvorrichtung Temperaturen von ca. 250 °C bis ca. 270 °C, die in einem Reflow-Lötofen typischerweise vorhanden sind, nicht standhalten. Anstelle oder zusätzlich zu Thermoplastmaterial ist Duroplastmaterial vorstellbar.

Zudem kann die Höhe, d.h. der Abstand der oberen Oberfläche der Sensorvorrichtung zu der ersten (oberen) Oberfläche des Leiterplattenelements 20 größer sein als die sonst üblicherweise maximal zulässige Bestückungshöhe (z.B. 25 mm bis 30 mm), die durch die freie Höhe des Reflow-Lötofen vorgegeben ist. Somit sind Getriebesteuerungseinrichtungen 10 mit Sensorvorrichtungen möglich, die einen maximalen Abstand (Abstand der oberen am weitesten entfernten Oberfläche) von der ersten Oberfläche des Leiterplattenelements 20 von ca. 25 mm bis ca. 100 mm und mehr zu der ersten Oberfläche aufweisen.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Getriebesteuerungseinrichtung (10), insbesondere für ein Kraftfahrzeug, umfassend ein Leiterplattenelement (20),
wobei auf einer ersten Oberfläche des Leiterplattenelements (20) ein Sockel (40) mit einem Hohlraum (42) zum Aufnehmen zumindest einen Teils eines Signaleingabeelements (50) befestigt ist,
wobei das Signaleingabeelement (50) zumindest teilweise in dem Hohlraum (42) befestigt ist und über den Sockel (40) elektrisch mit dem Leiterplattenelement (20) verbunden ist,
wobei das Leiterplattenelement (20) eine Aussparung (30) zum Einführen des Signaleingabeelements (50) in den Hohlraum (42) durch das Leiterplattenelement (20) aufweist,
wobei das Signaleingabeelement (50) als Sensorvorrichtung mit einem Sensordom, einem Sensor (60) und Anschlussleitungen (70, 71) ausgebildet ist, **dadurch gekennzeichnet, dass** eine erste Fixierungsschicht (80) zum Abdichten des Bereichs zwischen dem Sockel (40) und dem Leiterplattenelement (20) auf der ersten Oberfläche des Leiterplattenelements (20) und auf einem Teil des Sockels (40) angeordnet ist, wobei das Signaleingabeelement (50) über Anschlusselemente (43, 44) des Sockels (40) elektrisch mit dem Leiterplattenelement (20) verbunden ist, wobei die Anschlusselemente (43, 44) aus dem Sockel (40) in den Hohlraum (42) in Richtung des Signaleingabeelements (50) hervorstehen und die Anschlusselemente (43, 44) gegen eine oder mehrere Anschlussleitungen (70, 71) des Signaleingabeelements (50) drücken und auf diese Weise die Sensorvorrichtung zwischen sich einklemmen.

2. Getriebesteuerungseinrichtung (10) nach Anspruch 1, wobei
das Signaleingabeelement (50) eine zumindest teilweise außerhalb des Hohlraums (42) angeordnete Vertiefung (55) zum Aufnehmen einer zweiten Fixierungsschicht (81) aufweist.

3. Getriebesteuerungseinrichtung (10) nach einem der vorhergehenden Ansprüche, wobei
die Anschlusselemente (43, 44) federnd ausgebildet sind, und wobei das Signaleingabeelement (50) mittels der Anschlusselemente (43, 44) an dem Leiterplattenelement (20) befestigt ist.

4. Getriebesteuerungseinrichtung (10) nach einem der vorhergehenden Ansprüche, wobei
ein Teil des Signaleingabeelements (50) auf einer von dem Leiterplattenelement (20) abgewandten Seite des Sockels (40) aus dem Sockel (40) hervorsteht.

5. Getriebesteuerungseinrichtung (10) nach einem der vorhergehenden Ansprüche, wobei
der Sockel (40) in der Richtung von dem Leiterplattenelement (20) weg sich verjüngend ausgebildet ist.

6. Verfahren zum Befestigen eines Signaleingabeelements (50) an einem Leiterplattenelement (20) einer Getriebesteuerungseinrichtung (10), insbesondere für ein Kraftfahrzeug, wobei das Verfahren folgende Schritte umfasst:
Bereitstellen des Leiterplattenelements (20), wobei das Leiterplattenelement (20) eine Aussparung (30) zum Einführen des Signaleingabeelements (50) aufweist;
Anordnen eines Sockels (40) mit Anschlusselementen (43, 44) auf einer ersten Oberfläche des Leiterplattenelements (20), wobei der Sockel (40) die Aussparung (30) auf der ersten Oberfläche des Leiterplattenelements (20) im Wesentlichen umschließt und der Sockel (40) einen Hohlraum (42) zum Aufnehmen des Signaleingabeelements (50) aufweist;
wobei das Signaleingabeelement (50) als Sensorvorrichtung mit einem Sensordom, einem Sensor (60) und Anschlussleitungen (70, 71) ausgebildet ist;
Elektrisches Verbinden der Anschlusselemente (43, 44) mit dem Leiterplattenelement (20);
**gekennzeichnet, durch** die folgenden Schritte:
Aufbringen einer ersten Fixierungsschicht (80) auf die erste Oberfläche des Leiterplattenelements (20) und auf einen Teil des Sockels (40) zum Abdichten des Bereichs zwischen dem Sockel (40) und dem Leiterplattenelement (20);
Aushärten der ersten Fixierungsschicht (80);
und
Einführen des Signaleingabeelements (50) durch die Aussparung (30) des Leiterplattenelements (20) in den Hohlraum (42) des Sockels (40) und Befestigen des Signaleingabeelements (50) an dem Leiterplattenelement (20), wobei das Signaleingabeelement (50) über Anschlusselemente (43, 44) des Sockels (40) elektrisch mit dem Leiterplattenelement (20) verbunden wird, wobei die Anschlusselemente (43, 44) aus dem Sockel (40) in den Hohlraum (42) in Richtung des Signaleingabeelements (50) hervorstehen und die Anschlusselemente (43, 44) gegen eine oder mehrere Anschlussleitungen (70, 71) des Signaleingabeelements (50) drücken und auf diese Weise die Sensorvorrichtung zwischen sich einklemmen.

7. Verfahren nach Anspruch 6, wobei der in den Hohlraum (42) hervorstehende Teil des jeweiligen Anschlusselements (43, 44) federnd ausgebildet ist, und wobei das Signaleingabeelement (50) an dem Leiterplattenelement (20) mittels der in den Hohlraum (42) hervorstehenden Teile der Anschlusselemente (43, 44) befestigt wird.

8. Verfahren nach Anspruch 6 oder 7, wobei
das Signaleingabeelement (50) an unterschiedlichen Positionen in einer Richtung senkrecht zu der ersten Oberfläche des Leiterplattenelements (20) in dem Hohlraum (42) fixiert werden kann.

9. Verfahren nach einem der Ansprüche 6 bis 8, ferner folgenden Schritt umfassend:
Aufbringen einer zweiten Fixierungsschicht (81) auf einen Teil des Sockels (40) und einen Teil des Signaleingabeelements (50) zum Befestigen des Signaleingabeelements (50) an dem Sockel (40).

## Claims

1. Transmission control apparatus (10), in particular for a motor vehicle, comprising a circuit board element (20),
wherein a base (40) having a cavity (42) for receiving at least part of a signal input element (50) is attached to a first surface of the circuit board element (20),
wherein the signal input element (50) is at least partly attached in the cavity (42) and is electrically connected to the circuit board element (20) via the base (40),
wherein the circuit board element (20) has an opening (30) for the insertion of the signal input element (50) into the cavity (42) through the circuit board element (20),
wherein the signal input element (50) is formed as a sensor device having a sensor dome, a sensor (60) and connection lines (70, 71), **characterized in that** a first fixing layer (80) for sealing the area between the base (40) and the circuit board element (20) is arranged on the first surface of the circuit board element (20) and on part of the base (40), wherein the signal input element (50) is electrically connected to the circuit board element (20) via connection elements (43, 44) of the base (40), wherein the connection elements (43, 44) protrude from the base (40) into the cavity (42) in the direction of the signal input element (50) and press the connection elements (43, 44) against one or more connection lines (70, 71) of the signal input element (50) and thereby clamp the sensor device between them.

2. Transmission control apparatus (10) according to Claim 1, wherein
the signal input element (50) has a recess (55), arranged at least partly outside the cavity (42), for receiving a second fixing layer (81).

3. Transmission control apparatus (10) according to either of the preceding claims, wherein
the connection elements (43, 44) are designed so as to be flexible, and wherein the signal input element (50) is attached to the circuit board element (20) by way of the connection elements (43, 44).

4. Transmission control apparatus (10) according to one of the preceding claims, wherein
part of the signal input element (50) protrudes from the base (40) on a side of the base (40) facing away from the circuit board element (20).

5. Transmission control apparatus (10) according to one of the preceding claims, wherein
the base (40) is designed so as to taper in the direction away from the circuit board element (20).

6. Method for attaching a signal input element (50) to a circuit board element (20) of a transmission control apparatus (10), in particular for a motor vehicle, wherein the method comprises the following steps:
providing the circuit board element (20), wherein the circuit board element (20) has an opening (30) for the insertion of the signal input element (50);
arranging a base (40) having connection elements (43, 44) on a first surface of the circuit board element (20), wherein the base (40) substantially surrounds the opening (30) on the first surface of the circuit board element (20) and the base (40) has a cavity (42) for receiving the signal input element (50);
wherein the signal input element (50) is formed as a sensor device having a sensor dome, a sensor (60) and connection lines (70, 71);
electrically connecting the connection elements (43, 44) to the circuit board element (20);
**characterized by** the following steps:
applying a first fixing layer (80) to the first surface of the circuit board element (20) and to part of the base (40) in order to seal the area between the base (40) and the circuit board element (20);
curing the first fixing layer (80);
and
inserting the signal input element (50) through the opening (30) of the circuit board element (20) into the cavity (42) of the base (40) and attaching the signal input element (50) to the circuit board element (20), wherein the signal input element (50) is electrically connected to the circuit board element (20) via connection elements (43, 44) of the base (40), wherein the connection elements (43, 44) protrude from the base (40) into the cavity (42) in the direction of the signal input element (50) and press the connection elements (43, 44) against one or more connection lines (70, 71) of the signal input element (50) and thereby clamp the sensor device between them.

7. Method according to Claim 6, wherein that part of the respective connection element (43, 44) that protrudes into the cavity (42) is designed so as to be flexible, and wherein the signal input element (50) is attached to the circuit board element (20) by way of those parts of the connection elements (43, 44) that protrude into the cavity (42).

8. Method according to Claim 6 or 7, wherein
the signal input element (50) is able to be fixed in the cavity (42) at various positions in a direction perpendicular to the first surface of the circuit board element (20).

9. Method according to one of Claims 6 to 8, furthermore comprising the following step:
applying a second fixing layer (81) to part of the base (40) and part of the signal input element (50) in order to attach the signal input element (50) to the base (40).

## Revendications

1. Dispositif de commande de transmission (10), en particulier pour un véhicule automobile, comprenant un élément de carte de circuits imprimés (20),
dans lequel, sur une première surface de l'élément de carte de circuits imprimés (20) est fixée une embase (40) pourvue d'une cavité (42) pour recevoir au moins une partie d'un élément d'entrée de signal (50),
dans lequel l'élément d'entrée de signal (50) est fixé au moins en partie dans la cavité (42) et est relié électriquement à l'élément de carte de circuits imprimés (20) par l'intermédiaire de l'embase (40),
dans lequel l'élément de carte de circuits imprimés (20) présente un évidement (30) pour introduire l'élément d'entrée de signal (50) dans la cavité (42) à travers l'élément de carte de circuits imprimés (20),
dans lequel l'élément d'entrée de signal (50) est réalisé sous forme de dispositif capteur pourvu d'un dôme de capteur, d'un capteur (60) et de lignes de raccordement (70, 71), **caractérisé en ce qu'**une première couche de fixation (80) pour rendre étanche la zone entre l'embase (40) et l'élément de carte de circuits imprimés (20) est disposée sur la première surface de l'élément de carte de circuits imprimés (20) et sur une partie de l'embase (40), dans lequel l'élément d'entrée de signal (50) est relié électriquement à l'élément de carte de circuits imprimés (20) par l'intermédiaire d'éléments de raccordement (43, 44) de l'embase (40), dans lequel les éléments de raccordement (43, 44) dépassent de l'embase (40) dans la cavité (42) en direction de l'élément d'entrée de signal (50) et poussent les éléments de raccordement (43, 44) contre une ou plusieurs lignes de raccordement (70, 71) de l'élément d'entrée de signal (50) et prennent ainsi le dispositif capteur en sandwich entre eux.

2. Dispositif de commande de transmission (10) selon la revendication 1, dans lequel
l'élément d'entrée de signal (50) présente un creux (55) disposé au moins en partie à l'extérieur de la cavité (42) et destiné à recevoir une deuxième couche de fixation (81).

3. Dispositif de commande de transmission (10) selon l'une quelconque des revendications précédentes, dans lequel
les éléments de raccordement (43, 44) sont réalisés de manière élastique, et dans lequel l'élément d'entrée de signal (50) est fixé à l'élément de carte de circuits imprimés (20) au moyen des éléments de raccordement (43, 44) .

4. Dispositif de commande de transmission (10) selon l'une quelconque des revendications précédentes, dans lequel
une partie de l'élément d'entrée de signal (50) dépasse de l'embase (40) sur un côté de l'embase (40) détourné de l'élément de carte de circuits imprimés (20).

5. Dispositif de commande de transmission (10) selon l'une quelconque des revendications précédentes, dans lequel
l'embase (40) est réalisée en s'amincissant dans la direction s'éloignant de l'élément de carte de circuits imprimés (20) .

6. Procédé permettant de fixer un élément d'entrée de signal (50) à un élément de carte de circuits imprimés (20) d'un dispositif de commande de transmission (10), en particulier pour un véhicule automobile, le procédé comprenant les étapes suivantes consistant à :
fournir l'élément de carte de circuits imprimés (20), l'élément de carte de circuits imprimés (20) présentant un évidement (30) pour introduire l'élément d'entrée de signal (50) ;
disposer une embase (40) pourvue d'éléments de raccordement (43, 44) sur une première surface de l'élément de carte de circuits imprimés (20), l'embase (40) entourant substantiellement l'évidement (30) sur la première surface de l'élément de carte de circuits imprimés (20), et l'embase (40) présentant une cavité (42) pour recevoir l'élément d'entrée de signal (50) ;
dans lequel l'élément d'entrée de signal (50) est réalisé sous forme de dispositif capteur pourvu d'un dôme de capteur, d'un capteur (60) et de lignes de raccordement (70, 71) ;
relier électriquement les éléments de raccordement (43, 44) à l'élément de carte de circuits imprimés (20) ;
**caractérisé par** les étapes suivantes consistant à :
appliquer une première couche de fixation (80) sur la première surface de l'élément de carte de circuits imprimés (20) et sur une partie de l'embase (40) pour rendre étanche la zone entre l'embase (40) et l'élément de carte de circuits imprimés (20) ;
laisser durcir la première couche de fixation (80) ;
et
introduire l'élément d'entrée de signal (50) à travers l'évidement (30) de l'élément de carte de circuits imprimés (20) dans la cavité (42) de l'embase (40) et fixer l'élément d'entrée de signal (50) à l'élément de carte de circuits imprimés (20), dans lequel l'élément d'entrée de signal (50) est relié électriquement à l'élément de carte de circuits imprimés (20) par l'intermédiaire d'éléments de raccordement (43, 44) de l'embase (40), dans lequel les éléments de raccordement (43, 44) dépassent de l'embase (40) dans la cavité (42) en direction de l'élément d'entrée de signal (50) et poussent les éléments de raccordement (43, 44) contre une ou plusieurs lignes de raccordement (70, 71) de l'élément d'entrée de signal (50) et prennent ainsi le dispositif capteur en sandwich entre eux.

7. Procédé selon la revendication 6, dans lequel la partie dépassant dans la cavité (42) de l'élément de raccordement (43, 44) respectif est réalisée de manière élastique, et dans lequel l'élément d'entrée de signal (50) est fixé à l'élément de carte de circuits imprimés (20) au moyen des parties des éléments de raccordement (43, 44) qui dépassent dans la cavité (42).

8. Procédé selon la revendication 6 ou 7, dans lequel l'élément d'entrée de signal (50) peut être fixé dans la cavité (42) à différentes positions dans une direction perpendiculaire à la première surface de l'élément de carte de circuits imprimés (20).

9. Procédé selon l'une quelconque des revendications 6 à 8, comprenant en outre l'étape suivante consistant à : appliquer une deuxième couche de fixation (81) sur une partie de l'embase (40) et une partie de l'élément d'entrée de signal (50) pour fixer l'élément d'entrée de signal (50) à l'embase (40).
